(19) Europäisches Patentamt
European Patent Office
Office européen des brevets

(11) EP 2 166 053 A1

(12) **EUROPÄISCHE PATENTANMELDUNG**

(43) Veröffentlichungstag:
**24.03.2010 Patentblatt 2010/12**

(51) Int Cl.:
***C09J 7/02*** *(2006.01)* ***H01L 31/048*** *(2006.01)*

(21) Anmeldenummer: **09168778.0**

(22) Anmeldetag: **27.08.2009**

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**AL BA RS**

(30) Priorität: **18.09.2008 DE 102008047965**

(71) Anmelder: **TESA SE**
**20253 Hamburg (DE)**

(72) Erfinder:
- **Husemann, Marc Dr.**
  **22605, Hamburg (DE)**
- **Bunde, Bernd**
  **20253, Hamburg (DE)**
- **Storbeck, Reinhard Dr.**
  **22457, Hamburg (DE)**
- **Scherf, Lesmona**
  **20359, Hamburg (DE)**

(54) **Haftklebeband für Solarmodule**

(57) Haftklebeband, umfassend
(i) eine transparente Trägerfolie
(ii) eine Schicht einer transparenten Haftklebemasse,
**dadurch gekennzeichnet, dass**
- die Trägerfolie einen Brechungsindex $n_d^{20}$ von nicht mehr als 1,458 und eine Transmission von gleich oder größer 90 % aufweist,
- die Haftklebemassenschicht einen Brechungsindex $n_d^{20}$ von mindestnes 1,470 und eine Transmission von mindestens 90 % aufweist;
- die Transmission des Klebebandes im verklebten Zustand auf einer Glasplatte mindestens 90 % beträgt.

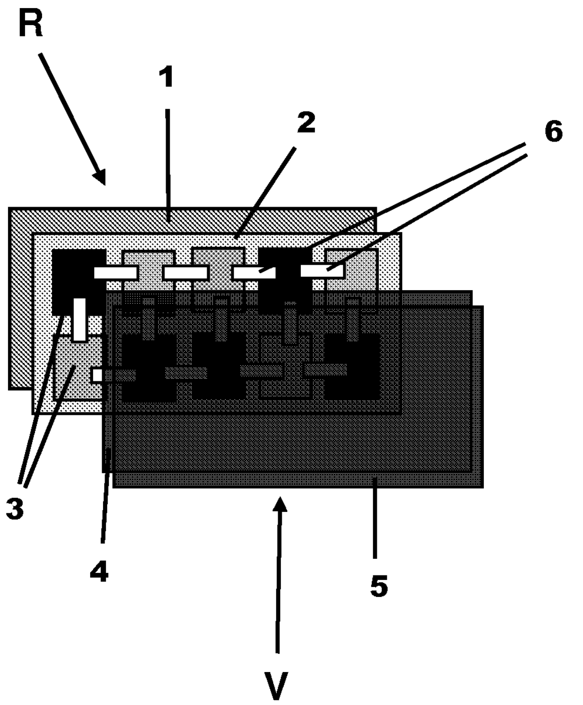


Fig. 1

EP 2 166 053 A1

## Beschreibung

Die Erfindung betrifft ein einseitiges Haftklebeband zur Herstellung von Solarmodulen. Im speziellen geht es um ein einseitiges Klebeband, welches in unterschiedlichen Bereichen bei der Herstellung und Verwendung von Solarmodulen eingesetzt werden kann.

In den letzten Jahren ist das Interesse an regenerativen Energiequellen, insbesondere Solarenergie, drastisch gestiegen. Ein sich exponentiell erhöhender globaler Energieverbrauch, die Knappheit an nicht erneuerbaren Energieträgern und rechtliche Regelungen zum Ökostrom werden in den nächsten Jahren zu einem starken Anstieg der Stromerzeugung durch Sonnenlicht führen. Eine Folge ist die verstärkte Forschung und Entwicklung im Bereich von Solarzellen und -modulen. Hierbei geht es vorrangig um Vereinfachung beziehungsweise Optimierung der Prozesse und Herstellungsverfahren und die Kostenreduktion der Rohstoffe und Materialien. Auch eine Reduktion der Gesamtdicke von Solarmodulen bei gleich bleibender Stabilität wird angestrebt.

Dickschichtsolarmodule mit Silizium-Solarzellen sind zurzeit auf dem Markt am stärksten vertreten und werden bevorzugt aus einem Laminat mit den eingebetteten Solarzellen, einer Glasfront und einem das Modul umgebenden Aluminiumrahmen angeboten. Die Produktion für Dünnschichtsolarmodule, wobei die Zellen zum Beispiel aus halbleitenden Materialien aufgedampft auf unterschiedlichen Substraten bestehen wird ausgeweitet.

Klebebänder werden vermehrt bei der Herstellung von Solarmodulen (in der Literatur auch als Solarpanels, Photovoltaikmodule und Solargeneratoren bezeichnet) eingesetzt, da sie prozessvereinfachend, sauber und kostengünstig sind. Beispiele für Klebebänder in Solarmodulen sind die Rahmen- und Schaltdosenverklebung, der Schutz der Glasoberfläche oder die Fixierung der Solarzellen vor dem Laminationsprozess. Bei dem Laminationsprozess eines Solarmoduls werden die empfindlichen Silizium-Solarzellen zwischen Folien einer Schmelzklebefolie bei etwa 150 °C für mindestens 15 Minuten im Vakuum eingebettet. Zum Beispiel die Rahmenverklebung wird bevorzugt mit einem doppelseitigen Klebeband anstatt mit einer Silikonverklebung durchgeführt, da der Prozess teilautomatisiert und somit schneller, einheitlicher und sauberer abläuft.

Für unterschiedliche Anwendungen während der Produktion von Modulen sind unterschiedliche, auf die Anwendungen abgestimmte Klebebänder im Markt.

Wichtige Anforderungen an die Klebebänder sind UV- und Witterungsbeständigkeit und optische Transparenz. Die UV- und Witterungsbeständigkeit sowie die mechanische Belastbarkeit von Solarmodulen werden durch Tests, welche in der IEC Norm 61215 beschrieben sind, überprüft. Aus den Angaben dieser Norm folgen die speziellen Klimabeständigkeitstestbedingungen unter denen auch die verwendeten Klebebänder konstante optische, chemische und klebtechnische Eigenschaften zeigen sollten.

Im Folgenden werden spezifische Klebebandanwendungen für Solarmodule beschrieben. Für einseitige Haftklebebänder bestehen die Anwendungen der Positionierung und Fixierung von Solarzellen (Graphik 1) sowie die Laminatfixierung (Graphik 2) vor dem Laminationsprozess und der Schutz der Glasfront (Graphik 2) von Solarmodulen.

Die Zellfixierung ist zurzeit ein hauptsächlich manuell durchgeführter Schritt während der Produktion des Moduls, bei dem die einzelnen empfindlichen Solarzellen auf der EVA-Schmelzfolie platziert und mit dem einseitigen Klebeband fixiert werden, damit sich die Zellen während des Laminationsschrittes nicht zueinander verschieben.

Bestehende Klebebandlösungen sind häufig mit einem Polypropylen bzw. Polyethylen- oder Celluloseacetatträgermaterial ausgerüstet, welche nachgewiesenerweise nach UV-Bestrahlung brüchig bzw. zerstört werden. Auch werden harzabgemischte Klebemassen in den heute eingesetzten Klebebändern verwendet die bei UV-Bestrahlung Verfärbung zeigen und unter Einfluss hoher Temperaturen ausgasen.

Somit besteht der Bedarf für ein Klebeband zur Zellenfixierung, welches ein verbessertes Ausgasungs- und Schrumpfverhalten sowie eine geringere Tendenz zur Blasenbildung besitzen sollte und ein Verschieben der Solarzellen bei hohen Temperaturen während der Lamination vermeidet. Zudem ist eine sehr gute UV-Beständigkeit des Klebebandes erforderlich, da das Zellenfixierungsband im Laminat verbleibt und eine Verfärbung oder Brüchigkeit des Klebebandes das optische äußere Erscheinungsbild des Solarmoduls mindern würde.

Das Laminatfixierungsklebeband erfüllt eine ähnliche Funktion wie das Klebeband zur Zellenfixierung, wobei in diesem Fall die verschiedenen Schichten des Modullaminats vor dem Verschieben geschützt werden sollen.

Zurzeit sind spezielle einseitige Klebebänder mit Silikonklebemassen in Gebrauch, die nach der Lamination der Schichten wieder entfernt werden, damit die Aluminiumprofile am Rand verklebt werden können. Dies bedeutet einen weiteren Prozessschritt, auf den man bevorzugter Weise verzichten möchte.

Es besteht somit der Bedarf nach einem dünnen Klebeband, welches nach der Lamination der Schichten im Solarmodul verbleiben kann und keine negativen Einfluß auf die Konstruktion bzw. die Funktionsweise des Solar Moduls aufweist. Dies betrifft ebenfalls die anschließende Aufbringung des Aluminiumrahmens.

Eine Glasschutzfolie auf der Glasfront eines Solarmoduls kann unterschiedliche Funktionen erfüllen wie zum Beispiel die verbesserte Transmission der Vorderseite des Moduls für einfallendes Licht oder einen Antisplitterschutz für die Glasoberfläche.

Bisherige Module sind häufig mit ca. 3 bis 4 mm dicken Schutzgläsern versehen um mechanische Stabilität des Gesamtmoduls zu sichern. Dies bedeutet für das Solarmodul ein relativ hohes Gewicht. Zur Verringerung der Schutzglasdicke besteht der Bedarf für eine Schutzfolie, die die darunter liegende Glasscheibe stabilisiert, so dass diese deutlich in der Schichtdicke reduziert werden kann. Zudem könnte die Schutzfolie noch funktionelle Schichten aufbringen, so dass eine spezielle Oberflächenbehandlung des Glases hinfällig wird.

Die beschriebenen Anwendungen verdeutlichen, dass sehr unterschiedliche Anforderungen je nach Einsatzweise des einseitigen Haftklebebandes im Solar Modul gefordert werden. Dies bedeutet zurzeit eine steigende Komplexität, da sehr verschiedene Haftklebebänder eingesetzt werden. Zur Vereinfachung und Beschleunigung des Herstellungsprozesses für Solarmodule besteht aber der Bedarf nach einem einseitigen Selbstklebeband, welches für alle aufgeführten und ähnlichen Anwendungen universell einsetzbar ist und die bestehenden Schwächen der zur Zeit bestehenden Lösungen minimiert bzw. nicht aufweist.

Gelöst werden kann die Aufgabe überraschend und nicht vorhersehbar durch ein hochtransparentes einseitiges Haftklebeband mit einem speziellen Trägeraufbau.

Gegenstand dieser Erfindung sind insbesondere einseitige Haftklebebänder, bestehend aus

i) einer transparenten Trägerfolie mit einem Brechungsindex $n_d^{20}$ (Brechungsindex für die Natrium-d-Linie entsprechend 589 nm bei 20 °C) von gleich oder kleiner 1,458 und einer Transmission gleich oder größer 90 %
ii) einer transparenten Haftklebemasse mit einem Brechungsindex $n_d^{20}$ von gleich oder größer 1,470 und einer Transmission gleich oder größer 90%,

wobei die Trägerfolie und Haftklebemasse dermaßen gewählt werden, dass Sie eine hoher UV-Beständigkeit, ein geringes Ausgasungsverhalten und eine hohe Temperaturbeständigkeit aufweisen und die Lichttransmission nach ASTM 1003 nach der Verklebung des einseitigen Haftklebebandes auf einer Glasscheibe eine Lichttransmission von gleich oder größer 90 % aufweist.

Bei der Auslegung und Gestaltung optischer Bauteile, wie z.B. Glasfenster, muss die Wechselwirkung der verwendeten Materialien mit der Art des eingestrahlten Lichts berücksichtigt werden. In einer abgeleiteten Version nimmt der Energieerhaltungssatz die Form

$$T(\lambda) + p(\lambda) + a(\lambda) = 1$$

an, wobei T(λ) den Anteil des transmittierten Lichts, p(λ) den Anteil des reflektierten Lichts und a(λ) den Anteil des absorbierten Lichts beschreibt (λ: Wellenlänge des Lichts) und wobei die Gesamtintensität des eingestrahlten Lichts auf 1 normiert ist. Je nach Anwendung des optischen Bauteils gilt es, einzelne dieser drei Terme zu optimieren und die jeweils anderen zu unterdrücken. Optische Bauteile, die für die Transmission ausgelegt werden, sollen sich durch Werte von T(λ), die nahe bei 1 liegen, auszeichnen. Dies erreicht man, indem p(λ) und a(λ) im Betrag reduziert werden. Transparente Acrylathaftklebemassen weisen normalerweise keine nennenswerte Absorption im sichtbaren Bereich, d. h. im Wellenlängenbereich zwischen 400 nm und 700 nm, auf. Dies kann leicht durch Messungen mit einem UV-Vis Spektralphotometer überprüft werden. Von entscheidendem Interesse ist daher p(λ). Reflexion ist ein Grenzflächenphänomen, das von den Brechungsindices $n_{d,i}$ von zwei in Kontakt tretenden Phasen i nach der Fresnel-Gleichung

$$\rho(\lambda) = \left( \frac{n_{d,2} - n_{d,1}}{n_{d,2} + n_{d,1}} \right)^2$$

abhängt. Für den Fall isorefraktiver Materialien, für die $n_{d,2} = n_{d,1}$ gilt, wird p(λ) = 0. Dies erklärt die Notwendigkeit, den Brechungsindex einer für optische Bauteile zu verwendenden Haftklebemasse denjenigen der zu verklebenden Materialien anzupassen. Typische Werte für verschiedene solcher Materialien sind in Tabelle 1 aufgeführt.

Tabelle 1

| Material | Brechungsindex $n_d$ |
|---|---|
| Quarzglas | 1,458 |
| Borkron (BK7) | 1,517 |

(fortgesetzt)

| Tabelle 1 | |
|---|---|
| Material | Brechungsindex $n_d$ |
| Borkron | 1,520 |
| Flint | 1,620 |
| (Quelle: Pedrotti, Pedrotti, Bausch, Schmidt, Optik, 1. Aufl. 1996, Prentice-Hall, München. Tabelle 5.1, Seite 158. Daten bei $\lambda$ = 588 nm) | |

Das erfindungsgemäße Klebeband ist dazu geeignet, bei der Herstellung von Solarmodulen vielfältige Aufgaben zu übernehmen, die ansonsten durch unterschiedliche Klebebänder verwirklicht werden müssen. Die Verwendung der erfindungsgemäßen Klebefolie bzw. Klebebänder ist ebenfalls Gegenstand der vorliegenden Erfindung.

Übliche Aufbauten von Solarmodulen lassen sich den Fig. 1 und 2 entnehmen. Solarmodule bestehen aus einer Vielzahl von Solarzellen, die insbesondere mit Vinylacetat Klebebändern miteinander fixiert sind, wobei diese Anordnung beidseitig mit Ethylen- -Folien abgedeckt wird. Die Rückseite des Solarmoduls besteht üblicherweise aus fluorierten Kunststoffen, die Vorderseite der Solarmodule bildet eine Glasscheibe. Auf die Darstellung der Kontaktierung der Solarzellen wurde in den Figuren verzichtet.

In den Figuren bedeuten:

R = Rückseite des Moduls
V = Vorderseite des Moduls
1 = fluorierte Folie
2, 4 = Ethylen-Vinylacetat-Folie (EVA-Folie)
3 = Solarzelle
5 = Glas
6 = erfindungsgemäßes Klebeband; eingesetzt zur Solarzellenfixierung (hier insbesondere als länglich ausgedehntes Flächengebilde vorteilhaft einsetzbar)
7 = erfindungsgemäße Klebefolie; eingesetzt als Oberflächenschutz (hier insbesondere als zweidimensional ausgedehntes Flächengebilde vorteilhaft einsetzbar)
8 = erfindungsgemäßes Klebeband; eingesetzt zur Laminatfixierung (hier insbesondere als länglich ausgedehntes Flächengebilde vorteilhaft einsetzbar)

In Figur 1 ist die erfindungsgemäße Fixierung der Solarzellen (3) miteinander bei der Herstellung des Solarmoduls gezeigt.

Fig. 2 zeigt erfindungsgemäße Verwendung zur vollflächigen oberflächenschützenden Beklebung der Glasscheibe (5) des Solarmoduls mit erfindungsgemäßen einseitigen Klebebändern (6), insbesondere als Wetterschutz und/oder als Verkratzungsschutz und ggf. zur Verstärkung der Glasscheibe, so dass die Schichtdicke der Glasscheibe reduziert werden kann. Fig. 2 zeigt weiterhin den erfindungsgemäßen Einsatz erfindungsgemäßer Klebebänder zur Fixierung des Laminats.

## Trägermaterialien

Zur Umsetzung der beschriebenen Erfindung werden unterschiedliche Anforderungen an das Trägermaterial gestellt. Besonders relevant ist hierbei die Transmission von Licht durch die Trägerfolie um eine optimale Lichtausbeute der Solarzellen zu garantieren und somit die Effektivität des Solarmoduls zu erhöhen.
Ein Brechungsindex des Trägermaterials von $n_d^{20}$ kleiner 1,458, bevorzugt unter 1,440 besonders bevorzugt unter 1,400 sorgt dabei für eine minimale Reflexion an der Grenzfläche und erhöht wiederum die Lichtausbeute. Sehr besitzt das Trägermaterial zusätzlich eine Transmission von größer 90 % (nach ASTM 1003), welche über lange Zeiträume bestehen bleibt.

Um die hohen elektrischen Anforderungen für eine Anwendung im und am Solarmodul zu erfüllen, besteht der Bedarf nach einem Trägermaterial mit einem hohen spezifischen Oberflächenwiderstand bzw. einem hohen spezifischen Durchgangswiderstandes. Es sollte ein spezifischer Durchgangswiderstand von > $10^{13}$ Ω cm und ein Oberflächenwiderstand von > $10^{15}$ Ω gegeben sein, um Kurzschlüsse zwischen den einzelnen Solarzellen bzw. den Leiterbahnen im Solarmodul oder auch zwischen dem Aluminiumrahmen des Solarmoduls und den Leitungen im Modul zu vermeiden. Bevorzugt bleiben diese Widerstände in einem breiten Temperaturbereich von -40 bis +85 °C bestehen, da Solarmodule starken Temperaturschwankungen ausgesetzt sind. Das Trägermaterial wird vorteilhaft dementsprechend ausgewählt.

Das eingesetzte Material sollte möglichst chemisch und physikalisch inert sein, um jegliche Veränderung des Materials durch äußere Einflüsse zu vermeiden. Es wird eine sehr geringe Wasseraufnahme gefordert, damit ein Quellen oder eine Zerstörung des Klebebandes durch Witterungseinflüsse vermieden wird. So kann auch eine Außenanwendung des Klebebandes an Solarmodulen die nötige Sicherheit bieten.

Die geforderten Eigenschaften an das Trägermaterial werden erfindungsgemäß bevorzugt durch fluorierte polyolefinische Kunststofffolien mit einem Fluorgehalt von gleich oder größer 15 Gew.-%, bevorzugt gleich oder größer 20 Gew.-% und besonders bevorzugt gleich oder größer 35 Gew.-% erreicht. Vorteilhaft werden Folien in Dicken von 12 bis 100 μm, bevorzugt in Dicken zwischen 20 und 50 μm eingesetzt. Die hervorragende Chemikalien- und Witterungs- bzw. Temperaturbeständigkeit, sowie die guten elektrischen und optischen Eigenschaften dieser Materialien zeichnen fluorierte polyolefinische Kunststofffolien für die beschriebenen Anwendungen aus.

Die erfindungsgemäß eingesetzten Folien zeichnet ein Brechungsindex $n_d^{20}$ (ASTM D-542-50, Abbe Refractometer; 20 °C) von kleiner 1,458 und eine Transmission von > 90 % (nach ASTM 1003), bevorzugt außerdem eine thermische Beständigkeit bis mindestens 170 °C bei mechanischer Beanspruchung aus, womit sie sich hervorragend für die aufgeführten Anwendungen eignen. Auch wird durch diese Materialien der Anspruch nach einem spezifischen Durchgangswiderstand von > $10^{13}$ Ω cm (ASTM D-257) und einem geringen Oberflächenwiderstand von > $10^{15}$ Ω (ASTM D-257) in dem gewünschten Temperaturbereich von -40 bis +85 °C erfüllt.

Aufgrund der reaktionsträgen Kohlenstoff-Fluor-Bindung in fluorhaltigen Polymeren zeigen diese hohe chemische und physikalische Beständigkeit in der Wärme und eine geringe Verfärbung bei UV-Bestrahlung. Eine geringe Wasserabsorption von <0,03 % kann mit der in ASTM D-570 beschriebenen Testmethode für fluorierte Folien nachgewiesen werden.

Beispiele für Materialien der eingesetzten Folien sind: Polyvinylfluorid (PVF), Polyethylentetrafluorethylen (PETFE), Tetrafluorethylen/Hexafluorethylencopolymer (FEP) oder Polyvinylidenfluorid (PVDF).

Neben einschichtigen Folien lassen sich aber auch mehrschichtige Folien einsetzen, die z.B. coextrudiert hergestellt werden. Erfindungsgemäß vorteilhaft können die zuvor genannten Polymermaterialien miteinander kombiniert werden. Um eine genügen hohen Splitterschutz zu gewährleisten, sollte die Folie bevorzugt eine Reißkraft von größer 150 MPa nach ASTM D 882 aufweisen.

Des Weiteren ist es vorteilhaft, die Folien vorab zu behandeln. So können z.B. Bedampfungen vorgenommen sein mit z.B. Zinkoxid, oder Lacke oder Haftvermittler aufgetragen sein, um die Haftung der Haftklebemasse zu verbessern. Weitere Methoden sind z.B. Corona-Behandlung und/oder Plasmavorbehandlungen und/oder das Ätzen der Folie.

Weiterhin kann es erforderlich sein, dass die Schutzfolie mit speziellen Beschichtungen ausgestattet wird.

Als optische Beschichtung eignen sich besonders bevorzugt Beschichtungen, die die Reflektion verringern und/oder die Verkratzung der Folie minimieren (sogenannte "Hard Coatings"). Die optischen Eigenschaften werden besonders bevorzugt über einen deutlich abgesenkten Brechungsindex für den Übergang Luft und optische Beschichtung erreicht. Dies ist besonders sinnvoll, wenn der Brechungsindex der Trägerfolie oberhalb 1,440 liegt. Generell kann zwischen Single- und Multi-Layer-Beschichtungen (Einschicht- und Mehrschicht-Beschichtungen) unterschieden werden. Im einfachsten Fall wird $MgF_2$ als Single-Layer-Beschichtung zur Minimierung der Reflektion eingesetzt.

$MgF_2$ weist einen Brechungsindex von 1,35 bei 550 nm auf. Weiterhin lassen sich z.B. Metalloxid-Schichten in verschiedenen Schichten zur Minimierung der Reflektion einsetzen. Typische Beispiele sind Schichten aus $SiO_2$ und $TiO_2$. Weitere geeignete Oxide sind z.B.. Hafniumoxid ($HfO_2$), Magnesiumoxid (MgO), Siliziummonoxid (SiO), Zirkonoxid ($ZrO_2$) und Tantaloxid ($Ta_2O_5$). Weiterhin können aber auch Nitride eingesetzt werden, wie z.B. $SiN_X$.

Des Weiteren können auch zusätzlich fluorierte Polymer als Schichten mit geringem Brechungsindex eingesetzt werden. Diese werden auch sehr häufig in Kombination mit den zuvor genannten Schichten aus $SiO_2$ und $TiO_2$ eingesetzt.

Des Weiteren können auch Sol-Gel-Prozesse eingesetzt werden. Hier werden z.B. Silikone, Alkoxide und/oder Metallalkoxide als Mischungen eingesetzt und damit beschichtet. Siloxane sind somit auch eine weit verbreite Basis für reflektionsmindernde Schichten. Die Siloxane können aber auch eine Antikratzwirkung aufweisen.

In einer bevorzugten Auslegung werden die Multilayer-Schichten dermaßen aufgebaut, dass die Schicht mit dem geringsten Brechungsindex zur Lichtstrahlseite des Glases vorgesehen ist und dann Schritt für Schritt der Brechungsindex zum Trägerfolie hin erhöht wird. Dies gilt für die außenseitige Verklebung des einseitigen Haftklebebandes auf dem Glas.

Die typischen Beschichtungsdicken liegen zwischen 2 und 1000 Å, mehr bevorzugt zwischen 100 und 500 Å (1 Å = $10^{-10}$ m). Zum Teil treten - je nach Schichtdicke und chemischer Zusammensetzung der einzelnen oder der mehreren optischen Schichten Farbveränderungen auf, die dann wiederum durch die Dicke der Beschichtung gesteuert

bzw. verändert werden können. Für den aus Lösung beschichteten Siloxan-Prozess können auch Schichtdicken von größer 1000 Å erzielt werden.

Eine weitere Möglichkeit zu Verringerung der Reflektion besteht in der Erzeugung von bestimmten Oberflächenstrukturen. So besteht die Möglichkeit der poröse Beschichtung und der Erzeugung von stochastischen oder periodischen Oberflächenstrukturen. Dabei sollte der Abstand zwischen den Strukturen deutlich kleiner sein als der Wellenlängenbereich des sichtbaren Lichtes.

Neben dem bereits erwähnten Prozess der Lösungsmittelbeschichtung können die optischen Schichten über Vakuum Beschichtungsverfahren, wie z.B. CVD (Chemical Vapor Deposition) oder PIAD (Plasma-Ion assisted Deposition), aufgetragen werden.

**Haftklebemasse**

In einer sehr bevorzugten Auslegung der Erfindung werden spezielle (Meth)Acrylathaftklebemassen eingesetzt.

Erfindungsgemäß vorteilhaft eingesetzte (Meth)Acrylathaftklebemassen, welche bevorzugt durch radikalische Polymerisation erhältlich sind, bestehen zu mindestens aus 50 Gew.-% auf zumindest einem acrylischen Monomer aus der Gruppe der Verbindungen der folgenden allgemeinen Formel:

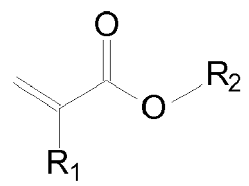

wobei $R_1$ = H oder $CH_3$ ist und der Rest $R_2$ = H oder $CH_3$ ist oder gewählt wird aus der Gruppe der verzweigten oder unverzweigten, gesättigten Alkylgruppen mit 1 - 30 Kohlenstoffatomen.

Die Monomere werden bevorzugt dermaßen gewählt, dass die resultierenden Polymere bei Raumtemperatur oder höheren Temperaturen als Haftklebemassen eingesetzt werden können, insbesondere derart, dass die resultierenden Polymere haftklebende Eigenschaften entsprechend des "Handbook of Pressure Sensitive Adhesive Technology" von Donatas Satas (van Nostrand, New York 1989) besitzen.

Die (Meth)acrylathaftklebemassen weisen einen Brechungsindex $n_d$ > 1,430 oder mehr bei 20 °C auf (Abbe Refraktomer; vgl. Prüfmethode A).

Die (Meth)acrylathaftklebemassen lassen sich bevorzugt durch Polymerisation einer Monomermischung gewinnen, welche sich aus Acrylsäureestern und/oder Methacrylsäureestern und/oder deren freien Säuren mit der Formel $CH_2 = C(R_1)(COOR_2)$ zusammensetzt, wobei $R_1$ = H oder $CH_3$ und $R_2$ eine Alkylkette mit 1 - 20 C-Atomen oder H ist.

Die Molmassen $M_w$ der eingesetzten Polyacrylate betragen bevorzugt $M_w \geq 200.000$ g/mol.

In einer sehr bevorzugten Weise werden Acryl- oder Methacrylmomonere eingesetzt, die aus Acryl- und Methacrylsäureester mit Alkylgruppen aus 4 bis 14 C-Atomen bestehen, bevorzugt 4 bis 9 C-Atomen umfassen. Spezifische Beispiele, ohne sich durch diese Aufzählung einschränken zu wollen, sind Methylacrylat, Methylmethacrylat, Ethylacrylat, n-Butylacrylat, n-Butylmethacrylat, n-Pentylacrylat, n-Hexylacrylat, n-Heptylacrylat, n-Octylacrylat, n-Octylmethacrylat, n-Nonylacrylat, Laurylacrylat, Stearylacrylat, Behenylacrylat, und deren verzweigten Isomere, wie z.B. Isobutylacrylat, 2-Ethylhexylacrylat, 2-Ethylhexylmethacrylat, Isooctylacrylat, Isooctylmethacrylat.

Weitere einzusetzende Verbindungsklassen sind monofunktionelle Acrylate bzw. Methacrylate von überbrückten Cycloalkylalkoholen, bestehend aus mindestens 6 C-Atomen. Die Cycloalkylalkohole können auch substituiert sein, z.B. durch C-1-6-Alkylgruppen, Halogenatomen oder Cyanogruppen. Spezifische Beispiele sind Cyclohexylmethacrylate, Isobornylacrylat, Isobornylmethacrylate und 3,5-Dimethyladamantylacrylat.

In einer Vorgehensweise werden Monomere eingesetzt, die polare Gruppen wie Carboxylreste, Sulfon- und Phosphonsäure, Hydroxyreste, Lactam und Lacton, N-substituiertes Amid, N-substituiertes Amin, Carbamat-, Epoxy-, Thiol-, Alkoxy-. Cyanreste, Ether oder ähnliches tragen.

Moderate basische Monomere sind z.B. N,N-Dialkylsubstituierte Amide, wie z.B. N,N-Dimethylacrylamid, N, N-Dimethylmethacrylamid, N-tert.-Butylacrylamid, N-Vinylpyrrolidon, N-Vinyllactam, Dimethylaminoethylmethacrylat, Dimethylaminoethylacrylat, Diethylaminoethylmethacrylat, Diethylaminoethylacrylat, N-Methylolmethacrylamid, N-(Buthoxymethyl)methacrylamid, N-Methylolacrylamid, N-(Ethoxymethyl)acrylamid, N-Isopropylacrylamid, wobei diese Aufzählung nicht abschließend ist.

Weitere bevorzugte Beispiele sind Hydroxyethylacrylat, Hydroxypropylacrylat, Hydroxyethylmethacrylat, Hydroxypropylmethacrylat, Allylalkohol, Maleinsäureanhydrid, Itaconsäureanhydrid, Itaconsäure, Glyceridylmethacrylat, Phenoxyethylacrlylat, Phenoxyethylmethacrylat, 2-Butoxyethylmethacrylat, 2-Butoxyethylacrylat, Cyanoethylmethacrylat, Cyanoethylacrylat, Glycerylmethacrylat, 6-Hydroxyhexylmethacrylat, Vinylessigsäure, Tetrahydrofufurylacrlyat, β-Acryloyloxypropionsäure, Trichloracrylsäure, Fumarsäure, Crotonsäure, Aconitsäure, Dimethylacrylsäure, wobei diese Aufzählung nicht abschließend ist.

In einer weiteren sehr bevorzugten Vorgehensweise werden als Monomere Vinylester, Vinylether, Vinylhalogenide, Vinylidenhalogenide, Vinylverbindungen mit aromatischen Cyclen und Heterocyclen in α-Stellung eingesetzt. Auch hier seien nicht ausschließlich einige Beispiele genannt: Vinylacetat, Vinylformamid, Vinylpyridin, Ethylvinylether, Vinylchlorid, Vinylidenchlorid und Acrylonitril.

Insbesondere werden besonders bevorzugt Comonomere eingesetzt, die zumindest einen Aromaten tragen, die eine Brechungsindex erhöhende Wirkung besitzen. Als Komponenten eigenen sich aromatische Vinylverbindungen, wie z.B. Styrol, wobei bevorzugt die aromatischen Kerne aus $C_4$- bis $C_{18}$-Bausteinen bestehen und auch Heteroatome enthalten können. Besonders bevorzugte Beispiele sind 4-Vinylpyridin, N-Vinylphthalimid, Methylstyrol, 3,4-Dimethoxystyrol, 4-Vinylbenzoesäure, Benzylacrylat, Benzylmethacrylat, Phenylacrylat, Phenylmethacrylat, t-Butylphenylacrylat, t-Butylphenylmethacrylat, 4-Biphenylacrylat und -methacrylat, 2-Naphthylacrylat und - methacrylat sowie Mischungen aus denjenigen Monomeren, wobei diese Aufzählung nicht abschließend ist.

Die (Meth)acrylathaftklebemassen weisen in einer bevorzugten Ausführungsvariante der Erfindung einen Brechungsindex $n_d$ > 1,47 bei 20 ° auf (gemessen mit dem Abbe Refraktomer; Prüfmethode A).

Durch die Erhöhung des aromatischen Anteils in der Zusammensetzung der Haftklebemasse steigt der Brechungsindex der Haftklebemasse an und die Streuung zwischen Glas und Haftklebemasse durch Licht wird minimiert. Der Einsatz aromatischer Comonomere verhilft daher zur Erhöhung des Brechunsgindex der Haftklebemasse.

Weiterhin können vorteilhaft Alterungsschutzmittel, z.B. in Form von primären und sekundären Antioxidantien oder in Form von Lichtschutzmitteln zugesetzt sein.

Zusätzlich können Vernetzer und Promotoren zur Vernetzung beigemischt werden. Beispiele sind z.B. bi- oder multifunktionelle Isocyanate (auch in blockierter Form) oder bi- oder multifunktionelle Epoxide. Weiterhin können auch thermisch aktivierbare Vernetzer, wie z.B. Lewis-Säure oder Metallchelate zugesetzt sein.

<u>Herstellverfahren für die (Meth)acrylathaftklebemassen</u>

Zur Polymerisation werden die Monomere dermaßen gewählt, daß die resultierenden Polymere bei Raumtemperatur oder höheren Temperaturen als Haftklebemassen eingesetzt werden können, insbesondere derart, daß die resultierenden Polymere haftklebende Eigenschaften entsprechend des "Handbook of Pressure Sensitive Adhesive Technology" von Donatas Satas (van Nostrand, New York 1989) besitzen.

Zur Erzielung einer für Haftklebemassen bevorzugten Glasübergangstemperatur $T_G$ der Polymere von $T_G \leq 25$ °C werden entsprechend dem vorstehend gesagten die Monomere sehr bevorzugt derart ausgesucht und die mengenmäßige Zusammensetzung der Monomermischung vorteilhaft derart gewählt, daß sich nach der ***Fox***-Gleichung (G1) (vgl. T.G. Fox, Bull. Am. Phys. Soc. 1 (1956) 123) der gewünschte $T_G$-Wert für das Polymer ergibt.

$$\frac{1}{T_G} = \sum_n \frac{w_n}{T_{G,n}} \qquad \text{(G1)}$$

Hierin repräsentiert n die Laufzahl über die eingesetzten Monomere, $W_n$ den Massenanteil des jeweiligen Monomers n (Gew.-%) und $T_{G,n}$ die jeweilige Glasübergangstemperatur des Homopolymers aus dem jeweiligen Monomeren n in K.

Zur Herstellung der Poly(meth)acrylathaftklebemassen werden in einer bevorzugten Auslegung aufgereinigte Monomere eingesetzt, d.h. die Monomere sind von Stabilisatoren befreit.

In einer bevorzugten Auslegung wird zur Herstellung eine konventionelle radikalische Polymerisationen durchgeführt. Für die radikalisch verlaufenden Polymerisationen werden bevorzugt Initiatorsysteme eingesetzt, die zusätzlich weitere radikalische Initiatoren zur Polymerisation enthalten, insbesondere thermisch zerfallende radikalbildende Azo- oder Peroxo-Initiatoren. Prinzipiell eignen sich jedoch alle für Acrylate dem Fachmann geläufigen, üblichen Initiatoren. Die Produktion von C-zentrierten Radikalen ist im Houben Weyl, Methoden der Organischen Chemie, Vol. E 19a, S. 60 - 147 beschrieben. Diese Methoden werden in bevorzugter Weise in Analogie angewendet.

Beispiele für Radikalquellen sind Peroxide, Hydroperoxide und Azoverbindungen, als einige nicht ausschließliche Beispiele für typische Radikalinitiatoren seien hier genannt Kaliumperoxodisulfat, Dibenzoylperoxid, Cumolhydroperoxid, Cyclohexanonperoxid, Di-t-butylperoxid, Azodiisosäurebutyronitril, Cyclohexylsulfonylacetylperoxid, Diisopropylpercarbonat, t-Butylperoktoat, Benzpinacol. In einer sehr bevorzugten Auslegung wird als radikalischer Initiator 1,1'-Azo-bis-(cyclohexancarbonsäurenitril) (Vazo 88™ der Fa. DuPont) oder Azodisobutyronitril (AIBN) verwendet.

Die mittleren Molekulargewichte $M_w$ der bei der radikalischen Polymerisation entstehenden Haftklebemassen

werden sehr bevorzugt derart gewählt, daß sie in einem Bereich von 200.000 bis 4.000.000 g/mol liegen; speziell für die weitere Verwendung als elektrisch-leitfähiger Schmelzhaftkleber mit Rückstellvermögen werden Haftklebemassen mit mittleren Molekulargewichten $M_w$ von 400.000 bis 1.400.000 g/mol hergestellt. Die Bestimmung des mittleren Molekulargewichtes erfolgt über Größenausschlusschromatographie (GPC; Eluent: THF mit 0,1 Vol.-% Trifluoressigsäure; Messung bei 25 °C; Vorsäule: PSS-SDV, 5 p, $10^3$ Å, ID 8,0 mm x 50 mm; Auftrennung: Säulen PSS-SDV, 5 p, $10^3$ sowie $10^5$ und $10^6$ Å mit jeweils ID 8,0 mm x 300 mm; Probenkonzentration: 4 g/l, Durchflussmenge; 1,0 ml pro Minute; Messung gegen PMMA-Standards).

Die Polymerisation kann in Substanz, in Gegenwart eines oder mehrerer organischer Lösungsmittel, in Gegenwart von Wasser oder in Gemischen aus organischen Lösungsmitteln und Wasser durchgeführt werden. Es wird dabei angestrebt, die verwendete Lösungsmittelmenge so gering wie möglich zu halten. Geeignete organische Lösungsmittel sind reine Alkane (z.B. Hexan, Heptan, Octan, Isooctan), aromatische Kohlenwasserstoffe (z.B. Benzol, Toluol, Xylol), Ester (z.B. Essigsäureethylester, Essigsäurepropyl-, -butyl- oder -hexylester), halogenierte Kohlenwasserstoffe (z.B. Chlorbenzol), Alkanole (z.B. Methanol, Ethanol, Ethylenglycol, Ethylenglycolmonomethylether) und Ether (z.B. Diethylether, Dibutylether) oder Gemische davon. Die wäßrigen Polymerisationsreaktionen können mit einem mit Wasser mischbaren oder hydrophilen Colösungsmittel versetzt werden, um zu gewährleisten, dass das Reaktionsgemisch während des Monomerumsatzes in Form einer homogenen Phase vorliegt. Vorteilhaft verwendbare Colösungsmittel für die vorliegende Erfindung werden gewählt aus der folgenden Gruppe, bestehend aus aliphatischen Alkoholen, Glycolen, Ethern, Glycolethern, Pyrrolidinen, N-Alkylpyrrolidinonen, N-Alkylpyrrolidonen, Polyethylenglycolen, Polypropylenglycolen, Amiden, Carbonsäuren und Salzen davon, Estern, Organosulfiden, Sulfoxiden, Sulfonen, Alkoholderivaten, Hydroxyetherderivaten, Aminoalkoholen, Ketonen und dergleichen, sowie Derivaten und Gemischen davon.

Die Polymerisationszeit beträgt - je nach Umsatz und Temperatur - zwischen 2 und 72 Stunden. Je höher die Reaktionstemperatur gewählt werden kann, das heißt, je höher die thermische Stabilität des Reaktionsgemisches ist, desto geringer kann die Reaktionsdauer gewählt werden.

Zur Initiierung der Polymerisation ist für die thermisch zerfallenden Initiatoren der Eintrag von Wärme essentiell. Die Polymerisation kann für die thermisch zerfallenden Initiatoren durch Erwärmen auf 50 bis 160 °C, je nach Initiatortyp, initiiert werden.

Ein anderes vorteilhaftes Herstellungsverfahren für die Poly(meth)acrylathaftklebemassen ist die anionische Polymerisation. Hier werden als Reaktionsmedium bevorzugt inerte Lösungsmittel verwendet, wie z.B. aliphatische und cycloaliphatische Kohlenwasserstoffe, oder auch aromatische Kohlenwasserstoffe.

Das lebende Polymer wird in diesem Fall im allgemeinen durch die Struktur $P_L(A)$-Me repräsentiert, wobei Me ein Metall der Gruppe I, wie z.B. Lithium, Natrium oder Kalium, und $P_L(A)$ ein wachsendes Polymer aus den Acrylatmonomeren ist. Die Molmasse des herzustellenden Polymers wird durch das Verhältnis von Initiatorkonzentration zu Monomerkonzentration kontrolliert. Als geeignete Polymerisationsinitiatoren eignen sich z. B. n-Propyllithium, n-Butyllithium, sec-Butyllithium, 2-Naphthyllithium, Cyclohexyllithium oder Octyllithium, wobei diese Aufzählung nicht den Anspruch auf Vollständigkeit besitzt. Ferner sind Initiatoren auf Basis von Samarium-Komplexen zur Polymerisation von Acrylaten bekannt und hier einsetzbar.

Weiterhin lassen sich auch difunktionelle Initiatoren einsetzen, wie beispielsweise 1,1,4,4-Tetraphenyl-1,4-dilithiobutan oder 1,1,4,4-Tetraphenyl-1,4-dilithioisobutan. Coinitiatoren lassen sich ebenfalls einsetzen. Geeignete Coinitiatoren sind unter anderem Lithiumhalogenide, Alkalimetallalkoxide oder Alkylaluminium-Verbindungen. In einer sehr bevorzugten Version sind die Liganden und Coinitiatoren so gewählt, daß Acrylatmonomere, wie z.B. n-Butylacrylat und 2-Ethylhexylacrylat, direkt polymerisiert werden können und nicht im Polymer durch eine Umesterung mit dem entsprechenden Alkohol generiert werden müssen.

Weiterhin wird die Polymerisation so gesteuert, der Umsatz der Polymerisation größer 99.5 % beträgt. Dies kann zum einen durch längere Polymerisationszeiten sowie durch eine höhere Polymerisationstemperatur erreicht werden. Weiterhin besteht bei radikalischen Polymerisationen die Möglichkeit, durch mehrfache Zugabe von schnell zerfallenden radikalischen Initiatoren den Polymerisationsumsatz zusteigern.

**Trennliner**

Zum Schutz der offenen Haftklebemasse wird das insbesondere einseitige Haftklebeband bevorzugt mit einem Trennliner eingedeckt. Als Trennpapiere eignen sich Glassine-, HDPE- oder LDPE-Liner, die in einer bevorzugten Auslegung eine Silikonisierung als Trennlage aufweisen. In einer sehr bevorzugten Auslegung der Erfindung wird ein Folientrennliner eingesetzt. Der Folientrennreleaseliner sollte in einer sehr bevorzugten Auslegung eine Silikonisierung als Trennmittel aufweisen. Des Weiteren sollte der Folientrennliner eine extrem glatte Oberfläche besitzen, so dass keine Strukturierung der Haftklebemasse durch den Trennliner vorgenommen wird. Dies wird bevorzugt durch die Verwendung von antiblockmittelfreien PET-Folien in Kombination mit Silikonsystemen, die aus Lösung beschichtet wurden, erreicht.

**Produktaufbauten**

Je nach Einsatzzweck kommen länglich ausgedehnte Flächengebilde oder zweidimensional ausgedehnte Flächengebilde zum Einsatz; siehe auch weiter oben. Je nach den Dimensionen gehen diese Ausführungsvariante ineinander über. Sofern im Rahmen dieser Schrift von Haftklebebändern oder von Haftklebefolien die Rede ist, hierdurch keine Unterscheidung der beiden Flächengebilde bewirkt werden, sofern dies nicht explizit angegeben ist. Insbesondere sollen bei der Beschreibung des Aufbaus jeweils beide Ausführungsvarianten umfasst sein.
Die Haftklebebänder können vorteilhaft wie folgt aufgebaut sein:

a] einschichtige Klebstofffolien bestehend aus einer Folienträgerschicht und einer Haftklebemasse,
b] einschichtige Klebstofffolien bestehend aus einer Folienträgerschicht, einer Haftklebemasse und einem Release-Liner.

Der Haftklebemassenauftrag beträgt erfindungsgemäß bevorzugt für einseitige Haftklebebänder zwischen 10 und 150 g/m$^2$, mehr bevorzugt zwischen 20 und 100 g/m$^2$.

**Verwendung**

Die Verwendung der einseitigen Haftklebebänder auf dem Glasfenster kann nach verschiedenen Mechanismen erfolgen. In einer erfinderischen Ausführung wird das Glasfenster vollflächig mit dem transparenten Klebeband verklebt. Das einseitige Haftklebeband wird dabei zur Sonnenseite ausgerichtet. Dies ist die bevorzugte erfinderische Variante. Des Weiteren kann aber auch das Haftklebeband auf der Rückseite des Schutzglases verklebt werden und ist somit zur Solarzelle gerichtet.
Die weitere erfinderische Verwendung umfasst den Einsatz des Klebebandes zur Zellfixierung von Solarzellen, wie sie in Fig. 1 dargestellt ist. Hierfür werden bevorzugt einzelne Haftklebebandstreifen eingesetzt. Eine weitere erfinderische Verwendung umfasst den Einsatz des Klebebandes zur Laminatfixierung, wie sie in Fig. 2 dargestellt ist. Hierfür werden wiederum bevorzugt Haftklebebandstreifen eingesetzt.

**Applikation**

Im ersten Schritt wird in einer bevorzugten Vorgehensweise das einseitige Haftklebeband auf die Nutzbreite bzw. auf die erforderliche Nutzgröße (Flächengröße) geschnitten.
Für die Verklebung als Splitterschutzfolie wird im folgenden Schritt vollflächig auf das Glas laminiert. Hierfür wird in einem ersten Schritt die Trennfolie entfernt, und dann mit der offenen Haftklebemasse auf das Glasfenster laminiert. Hierfür kann es erforderlich sein, das Glas bzw. die Haftklebemasse zu befeuchten (z.B. mit Wasser oder mit einer Seifenlösung), damit die Haftklebemasse blasenfrei und großflächig laminiert werden kann.
Generell gilt für alle Applikationen, dass das einseitige Haftklebeband von einer Seite auflaminiert wird, so dass von der anderen Seite die Luft entweichen kann. Dies kann z.B. durch eine Druckwalze oder Gummiroller oder Rollrakel oder Quetschwalze oder Spachtel erfolgen.

Prüfmethoden

A. Brechungsindex

Der Brechungsindex der Haftklebemasse und der fluorierten Polymerfolien wird nach ASTM D-542-50 (25 µm dicke Messproben; 20 °C; 589 nm) nach dem Abbeschen Prinzip gemessen.

B. Transmission

Die Bestimmung der Transmission bei 550 nm erfolgt nach ASTM D1003. Vermessen wurde der Verbund aus optisch transparentem Klebeband und Glasplatte. Im Vergleich hierzu wurde ebenfalls dazu nach 1000 h Lagerung bei 85 °C gemessen.

C. Klebkraft

Die Prüfung der Schälfestigkeit (Klebkraft) erfolgte gemäß PSTC-1. Das Klebeband wird auf eine Glasplatte

aufgebracht. Ein 2 cm breiter Streifen des Klebebandes wird durch dreimaliges doppeltes Überrollen mittels einer 2 kg Rolle verklebt. Die Platte wird eingespannt und der Selbstklebestreifen über sein freies Ende an einer Zugprüfmaschine unter einem Schälwinkel von 180° mit einer Geschwindigkeit von 300 mm/min abgezogen. Die Kraft wird in N/cm angegeben.

D. Lichtbeständigkeit

Der Verbund aus Klebeband und Glasplatte wird in der Größe 4 x 20 $cm^2$ zur Hälfte mit einem Pappstreifen abgedeckt und dann für eine Dauer von 300 h mit Lampen des Typs Osram Ultra Vitalux 300 W in einem Abstand von 50 cm bestrahlt. Nach der Bestrahlung wird der Pappstreifen entfernt und die Verfärbung optisch beurteilt.
Der Test wird bestanden, wenn die Prüfstreifen gar keine unterschiedlichen Verfärbungen aufweisen und der Träger sich nicht zersetzt.

E. Kugelfalltest

Das Klebeband wird auf eine 1,1 mm dicke Glasscheibe der Firma Schott blasenfrei fixiert. Die Verklebungsfläche beträgt 4 x 6 cm. Anschließend wurde der Verbund 48 h bei 23 °C und 50 % Feuchtigkeit (rel. Feuchte) gelagert. Dann wird der Verbund in einer Aufnahme fixiert, so dass die Glasoberfläche horizontal ausgerichtet ist (die Glasseite befindet sich oben). 1 m oberhalb der Glasfläche wird eine Stahlkugel mit 63,7 g fixiert. Dann wird die Stahlkugel dem freien Fall ausgesetzt. Der Test gilt als bestanden, wenn sich weniger als 5 Gew.- % der Glassplitter nach dem Kugelfalltest lösen. Der Verlust wird gravimetrisch bestimmt (Bestimmung des Gewichtes vor und nach dem Kugelfalltest.

F. Elektrische Leitfähigkeit

Die Messung des Volumenwiderstandes erfolgte nach ASTM D-257-78. Die Messung erfolgte bei 23 °C und 100 °C. Die Werte werden in Ωcm angeben.

G. Klebkraft bei 150°C

Die Prüfung der Schälfestigkeit (Klebkraft) erfolgte gemäß PSTC-1. Das Klebeband wird auf eine Glasplatte aufgebracht. Ein 2 cm breiter Streifen des Klebebandes durch sechsmaliges Überrollen mittels einer 2 kg Rolle verklebt. Die Platte wird eingespannt und auf 150 °C temperiert, bis das Klebeband diese Temperatur erreicht hat.. Der Selbstklebestreifen wird über sein freies Ende an einer Zugprüfmaschine unter einem Schälwinkel von 180° mit einer Geschwindigkeit von 300 mm/min abgezogen. Die Kraft wird in N/cm angegeben.

Herstellung des Polymer 1:

Für die Polymerisation wurden von Stabilisatoren gereinigte Monomere eingesetzt. Die Monomere wurden durch Destillation aufgereinigt. Ein für radikalische Polymerisationen konventioneller 2 L-Glasreaktor wurde mit 80 g Acrylsäure, 140 g n-Butylacrylat, 200 g 2-Ethylhexylacrylat, und 300 g Aceton/Isopropanol (97:3) befüllt. Nach 45 Minuten Durchleiten mit Stickstoffgas unter Rühren wurde der Reaktor auf 58°C hochgeheizt und 0,2 g Vazo67™ (2,2'-azodi(2-methylbutyronitril), Fa. DuPont) hinzugegeben. Anschließend wurde das äußere Heizbad auf 75 °C erwärmt und die Reaktion konstant bei dieser Außentemperatur durchgeführt. Nach 1 h Reaktionszeit wurde wiederum 0,2 g Vazo 67™ (2,2'-azodi(2-methylbutyronitril), Fa. DuPont) hinzugegeben. Nach 3 und 6 h wurde mit jeweils 150 g Aceton/ Isopropanol Gemisch verdünnt. Zur Reduktion der Restinitiatoren wurden nach 8 und nach 10 h jeweils 0,4 g Perkadox 16™ (Di(4-tert-butylcyclohexyl) peroxydicarbonate, Fa. Akzo Nobel) hinzugegeben. Die Reaktion wurde nach 48 h Reaktionszeit abgebrochen und auf Raumtemperatur abgekühlt. Der Polymerumsatz betrug 99,6 % (bestimmt via GC-MS). Der Brechungsindex gemessen nach Testmethode A betrug 1,475.

Herstellung des Polymer 2:

Für die Polymerisation wurden von Stabilisatoren gereinigte Monomere eingesetzt. Die Monomere wurden durch Destillation aufgereinigt. Ein für radikalische Polymerisationen konventioneller 2 L-Glasreaktor wurde mit 60 g Acrylsäure, 340 g n-Butylacrylat und 300 g Aceton/Isopropanol (97:3) befüllt. Nach 45 Minuten Durchleiten mit Stickstoffgas unter Rühren wurde der Reaktor auf 58 °C hochgeheizt und 0,2 g Vazo 67™ (2,2'-azodi(2-methylbutyronitril), Fa. DuPont) hinzugegeben. Anschließend wurde das äußere Heizbad auf 75°C erwärmt und die Reaktion konstant bei

dieser Außentemperatur durchgeführt. Nach 1 h Reaktionszeit wurde wiederum 0,2 g Vazo 67™ (2,2'-azodi(2-methylbutyronitril), Fa. DuPont) hinzugegeben. Nach 3 und 6 h wurde mit jeweils 150 g Aceton/Isopropanol Gemisch verdünnt. Zur Reduktion der Restinitiatoren wurden nach 8 und nach 10 h jeweils 0,4 g Perkadox 16™ (Di(4-tert-butylcyclohexyl) peroxydicarbonate, Fa. Akzo Nobel) hinzugegeben. Die Reaktion wurde nach 48 h Reaktionszeit abgebrochen und auf Raumtemperatur abgekühlt. Der Polymerumsatz betrug 99,7 % (bestimmt via GC-MS). Der Brechungsindex gemessen nach Testmethode A betrug 1,474.

Herstellung des Polymer 3:

Ein für radikalische Polymerisationen konventioneller 2 L-Glasreaktor wurde mit 60 g Acrylsäure, 340 g n-Butylacrylat und 300 g Aceton/Isopropanol (97:3) befüllt. Nach 45 Minuten Durchleiten mit Stickstoffgas unter Rühren wurde der Reaktor auf 58 °C hochgeheizt und 0,2 g Vazo 67™ (2,2'-azodi(2-methylbutyronitril), Fa. DuPont) hinzugegeben. Anschließend wurde das äußere Heizbad auf 75 °C erwärmt und die Reaktion konstant bei dieser Außentemperatur durchgeführt. Nach 1 h Reaktionszeit wurde wiederum 0,2 g Vazo 67™ (2,2'-azodi(2-methylbutyronitril), Fa. DuPont) hinzugegeben. Nach 3 und 6 h wurde mit jeweils 150 g Aceton/Isopropanol Gemisch verdünnt. Die Reaktion wurde nach 24 h Reaktionszeit abgebrochen und auf Raumtemperatur abgekühlt. Der Polymerumsatz betrug 97,6 % (bestimmt via GC-MS). Anschließend wurde in Lösung mit 30 Gew.-% Sylvares™ TP 95 (Terpenphenol Harz, Erweichungstemperatur 95 °C, Fa. Arizona) homogen abgemischt. Der Brechungsindex betrug nach der Abmischung gemessen nach Testmethode A 1,479.

Abmischung der Vernetzerlösung:

Die Polymerlösung 1 oder 2 wurde unter Rühren mit jeweils 0,3 Gew.-% Aluminium(III)acetylacetonat abgemischt und mit Aceton auf 30 % Feststoffgehalt verdünnt.

Folie 1

Als Folie 1 wurde eine Polyvinylfluorid-Folie mit einer Schichtdicke von 25 µm eingesetzt. Der Gewichtsanteil Fluor beträgt 41 %. Der Brechungsindex gemessen nach Testmethode A betrug 1,458.

Folie 2

Als Folie 2 wurde eine Ethylen-Tetrafluoroethylen Copolymerfolie mit einer Schichtdicke von 25 µm eingesetzt. Der Gewichtsanteil Fluor beträgt 59 %. Der Brechungsindex gemessen nach Testmethode A betrug 1,398.

Referenz Folie 1

Als Referenzfolie 1 wurde eine HDPE Folie mit einer Schichtdicke von 25 µm eingesetzt. Der Gewichtsanteil Fluor beträgt 0 %. Der Brechungsindex gemessen nach Testmethode A betrug 1,540.

Referenz Folie 2

Als Referenzfolie 2 wurde eine PET Folie mit einer Schichtdicke von 25 µm eingesetzt. Der Gewichtsanteil Fluor beträgt 0 %. Der Brechungsindex gemessen nach Testmethode A betrug 1,604.

Herstellung des Klebebandmusters Beispiel 1:

Folie 1 wurde mit Polymer 1 mittels eines Streichbalkens beschichtet. Anschließend wurde langsam das Lösungsmittel abgedampft. Die Klebebandmuster wurden dann 10 Minuten bei 120°C getrocknet. Der Masseauftrag betrug nach dem Trocknen 50 g/m$^2$.

Herstellung des Klebebandmusters Beispiel 2:

Folie 1 wurde mit Polymer 2 mittels eines Streichbalkens beschichtet. Anschließend wurde langsam das Lösungsmittel abgedampft. Die Klebebandmuster wurden dann 10 Minuten bei 120°C getrocknet. Der Masseauftrag betrug nach dem Trocknen 50 g/m$^2$.

Herstellung des Klebebandmusters Beispiel 3:

Folie 2 wurde mit Polymer 1 mittels eines Streichbalkens beschichtet. Anschließend wurde langsam das Lösungsmittel abgedampft. Die Klebebandmuster wurden dann 10 Minuten bei 120°C getrocknet. Der Masseauftrag betrug nach dem Trocknen 50 g/$m^2$.

Herstellung des Klebebandmusters Beispiel 4:

Folie 2 wurde mit Polymer 2 mittels eines Streichbalkens beschichtet. Anschließend wurde langsam das Lösungsmittel abgedampft. Die Klebebandmuster wurden dann 10 Minuten bei 120°C getrocknet. Der Masseauftrag betrug nach dem Trocknen 50 g/$m^2$.

Herstellung des Klebebandmusters Referenzbeispiel 1:

Referenzfolie 1 wurde mit Polymer 3 mittels eines Streichbalkens beschichtet. Anschließend wurde langsam das Lösungsmittel abgedampft. Die Klebebandmuster wurden dann 10 Minuten bei 120°C getrocknet. Der Masseauftrag betrug nach dem Trocknen 50 g/$m^2$.

Herstellung des Klebebandmusters Referenzbeispiel 2:

Referenzfolie 2 wurde mit Polymer 3 mittels eines Streichbalkens beschichtet. Anschließend wurde langsam das Lösungsmittel abgedampft. Die Klebebandmuster wurden dann 10 Minuten bei 120°C getrocknet. Der Masseauftrag betrug nach dem Trocknen 50 g/$m^2$.

**Ergebnisse**

Nach der Prüfmusterherstellung wurden zunächst von allen Beispielen die Klebkräfte auf Glas vermessen. Es wurde hierbei nach Prüfmethode C Klebkraft vorgegangen. Die Werte sind in Tabelle 1 zusammengefasst.

Tabelle 1

| Beispiel | KK Glas (Test C) |
|---|---|
| 1 | 4,3 |
| 2 | 4,0 |
| 3 | 4,4 |
| 4 | 4,3 |
| Referenz1 | 5,4 |
| Referenz2 | 5,7 |
| KK: Sofortklebkraft in N/cm | |

Aus den gemessenen Werten geht hervor, dass die eingesetzten Haftklebebänder hohe Sofortklebkräften auf Glas aufweisen und somit eine gute Haftung aufbauen. Zwischen den erfinderischen Beispielen und den Referenzbeispielen 1 und 2 bestand ein kleiner Unterschied. Die Referenzbeispiele wiesen ein etwas höheres Klebkraftniveau auf.

Des Weiteren wurden mit allen Beispielen der Transmissionstest B durchgeführt. Hiermit wurde überprüft, ob bei Verklebung des Splitterschutzklebebandes mit dem Glasfenster eine genügend hohe Transmission zur Verfügung steht. Die gemessenen Werte des Verbundes sind in Tabelle 2 dargestellt.

Tabelle 2

| Beispiel | Transmission (Test B, sofort) | Transmission (Test B, 1000 h) |
|---|---|---|
| 1 | 91 % | 91 % |
| 2 | 92 % | 92 % |
| 3 | 91 % | 91 % |

(fortgesetzt)

| Tabelle 2 | | |
|---|---|---|
| Beispiel | Transmission (Test B, sofort) | Transmission (Test B, 1000 h) |
| 4 | 91 % | 91 % |
| Referenz1 | 68 % | 65 % |
| Referenz2 | 92 % | 84 % |

Der Tabelle 2 kann entnommen werden, dass alle Beispiele 1 - 4 äußerst hohe Transmissionswerte von 90 % oder höher aufweisen. Referenzbeispiel 1 zeigt, das die Transmission deutlich herabgesetzt wird durch den nicht-transparenten Träger. Referenzbeispiel 2 belegt, dass nach der Alterung die Transmission deutlich abgenommen hat und unterhalb des Zielwertes liegt. Dagegen sind die erfinderischen Beispiele 1 - 4 alles stabil gegen Temperaturalterung.

Weiterhin wurden alle Beispiele dem Kugelfalltest E unterzogen. Die Ergebnisse sind in der folgenden Tabelle 3 dargestellt.

| Tabelle 3 | |
|---|---|
| Beispiel | Kugelfalltest (Test E) |
| 1 | < 2 Gew.-%* |
| 2 | < 2 Gew.-%* |
| 3 | < 2 Gew.-%* |
| 4 | < 2 Gew.-%* |
| Referenz1 | < 2 Gew.-%* |
| Referenz2 | < 2 Gew.-%* |
| Glas (3 mm) | 100 Gew.-%* |
| *bezogen auf das Gewichts des Glases | |

Den Ergebnissen kann entnommen werden, dass durch den gezielten Aufbau der Klebebänder (Struktur des Backings als auch der Klebemasse) das Eigenschaftsprofil so optimiert ist, dass ein sehr guter Splitterschutz besteht. Der Test wurden mit alle Beispielen (1-4) deutlich bestanden In keinem Fall lösten sich mehr als 2 Gew.-% der Glassplitter. Die Referenzbeispiele zeigten ebenfalls einen sehr guten Splitterschutz. Weiterhin wurde als Referenz noch ein 3 mm dickes Glas dem Kugelfalltest unterzogen. Das Ergebnis belegt, dass das Glas durch den Aufprall der Kugel zerbricht. Somit konnte gezeigt werden, dass durch die Beispiele (alle durchgeführt mit einer 1.1 mm dicken Glasplatte) ein Splitterschutz gewährleistet wird und somit die Gläser dünner ausgelegt werden können und somit Gewicht gespart werden kann.

Für die Simulierung der Dauerbestrahlung durch Außenlicht wurde zudem der Lichtbeständigkeitstest D durchgeführt. Hier werden die Beispiele 300 h mit intensiven Glühlampen bestrahlt, die die Sonnenlichteinwirkung simulieren. Die Ergebnisse sind in Tabelle 4 zusammengefügt.

| Tabelle 4 | |
|---|---|
| Beispiel | Lichtbeständigkeit (Test D) |
| 1 | Bestanden |
| 2 | Bestanden |
| 3 | Bestanden |
| 4 | Bestanden |
| Referenz1 | Verfärbung |
| Referenz2 | Verfärbung/Zersetzung Träger |

Die Ergebnisse belegen, dass die Beispiele 1 bis 4 hohe Alterungsstabilitäten besitzen.
Somit lassen sich die erfindungsgemäßen Haftklebebänder auch für Langzeitanwendungen einsetzen. Es tritt keine Verfärbung ein noch treten Zersetzungen des Trägers auf, die den Lichteinfall reduzieren bzw. mechanisch auflösen. Die Referenzbeispiele 1 und 2 zeigen dagegen eine deutliche Verfärbung und im Fall des Beispiels 2 tritt ebenfalls eine Zersetzung des Trägermaterials ein.

Die bisherigen Prüfungen haben gezeigt, dass die erfinderischen Beispiele sehr gut als Splitterschutzhaftklebeband für Glasscheiben in Solar Panels geeignet sind. Zur Überprüfung der Eignung als Haftklebeband zur Solarzellenfixierung bedarf es aber noch weiterer Anforderungen, da hier Kontakt direkt zu elektrisch leitfähigen Verbindungen besteht und somit diese durch die Verklebung mit dem Haftklebeband nicht negativ beeinflusst werden sollten. Daher wurden elektrische Leitfähigkeitsmessungen nach Testmethode F durchgeführt. Bewertet wurde die elektrische Leitfähigkeit des Trägermaterials und der Haftklebemasse. Die Ergebnisse sind in Tabelle 5 dargestellt.

Tabelle 5

| Beispiel | Elektrische Leitfähigkeit (Test F) 23°C / Träger | Elektrische Leitfähigkeit (Test F) 23°C / Haftklebemasse | Elektrische Leitfähigkeit (Test F) 100°C / Haftklebemasse |
|---|---|---|---|
| 1 | $10^{13}$ Ω cm | $10^{15}$ Ω cm | $10^{12}$ Ω cm |
| 2 | $10^{13}$ Ω cm | $10^{15}$ Ω cm | $10^{12}$ Ω cm |
| 3 | $10^{16}$ Ω cm | $10^{15}$ Ω cm | $10^{12}$ Ω cm |
| 4 | $10^{16}$ Ω cm | $10^{15}$ Ω cm | $10^{12}$ Ω cm |
| Referenz1 | $10^{16}$ Ω cm | $10^{14}$ Ω cm | $10^{10}$ Ω cm |
| Referenz2 | $10^{16}$ Ω cm | $10^{14}$ Ω cm | $10^{10}$ Ω cm |

Die Werte in Tabelle 5 belegen, dass die Trägermaterialen der Beispiele 1 bis sowie der Referenzbeispiele 1 und 2 alle hohe elektrische Widerstände aufweisen und damit sehr gute Isolatoren sind. Dies gilt ebenso für die elektrische Leitfähigkeit der Haftklebemassen. Nur die Messung bei 100°C zeigen, dass die elektrische Leitfähigkeit im Allgemeinen zunimmt. Insbesondere die Referenzbeispiele 1 und 2 belegen, dass bei hoher Temperatur die Haftklebemasse zu einer erhöhten elektrischen Leitfähigkeit neigt.
Dies könnte ein Problem bedeuten, da die Solar Panels sich in der Sommerzeit unter starkem Lichteinfall sehr stark aufheizen können und somit die ansteigende elektrische Leitfähigkeit ein Problem für z.B. Kurzschlüsse aber auch Korrosion darstellen kann.

Für das Haftklebeband zur Fixierung des Laminates besteht weiterhin die Anforderung, dass das Haftklebeband einen Hochtemperaturprozess durchlaufen muss. Daher wurde zusätzlich noch ein Klebkrafttest bei 150°C durchgeführt. Dabei wurde nach Testmethode G vorgegangen. Die Ergebnisse sind in der folgenden Tabelle 6 dargestellt.

Tabelle 6

| Beispiel | Klebkraft (Test G) 150°C |
|---|---|
| 1 | 0.7 N/cm |
| 2 | 0.8 N/cm |
| 3 | 0.7 N/cm |
| 4 | 0.7 N/cm |
| Referenz1 | n.d. |
| Referenz2 | 0.2 N/cm |
| n.d. Nicht messbar, da Träger bei 150°C deutlich zu weich ist | |

Tabelle 6 kann entnommen werden, dass die Klebkräfte der erfinderischen Beispiele 1 bis 4 deutlich abgenommen haben. Gegenüber der Referenz2 können aber immer noch höhere Klebkräfte gemessen werden, so dass auffällt, dass Referenz2 sehr deutlich an Klebkraft bei sehr hohen Temperaturen verliert und somit nicht sehr für Hochtemperaturverklebungen geeignet. Probleme können vor allem mit Repulsionskräfte und Spannungen auftreten, die sich bei 150°C ausbilden und somit zum Ablösen des Haftklebebandes führen können. Referenzbeispiel 1 ist dagegen überhaupt nicht einsetzbar, da hier der Träger bei 150°C sehr stark erweicht. Die Beispiele 1 bis 4 zeigen dagegen ein sehr ausgewogenes Verhalten und können somit sehr gut für die Laminatfixierung eingesetzt werden. Zudem beträgt die Gesamtdicke der Beispiele 1 bis 4 ca. 75 µm, so dass anschließend noch Aluminiumrahmenprofile darüber verklebt werden können. Diese werden dann mit doppelseitigen Schaumstoffhaftklebebändern fixiert, die 75 µm Unebenheiten durch den Verbleib des Haftklebebandes kompensieren können.

**Patentansprüche**

**1.** Haftklebeband, umfassend

(i) eine transparente Trägerfolie
(ii) eine Schicht einer transparenten Haftklebemasse,

**dadurch gekennzeichnet, dass**

- die Trägerfolie einen Brechungsindex $n_d^{20}$ von nicht mehr als 1,458 und eine Transmission von gleich oder größer 90 % aufweist,
- die Haftklebemassenschicht einen Brechungsindex $n_d^{20}$ von mindestens 1,470 und eine Transmission von mindestens 90 % aufweist;
- die Transmission des Klebebandes im verklebten Zustand auf einer Glasplatte mindestens 90 % beträgt.

**2.** Haftklebeband nach Anspruch 1, **dadurch gekennzeichnet, dass** der Brechungsindex $n_d^{20}$ der Trägerfolie nicht mehr als 1,440, bevorzugt nicht mehr als 1,400 beträgt.

**3.** Haftklebeband nach einem der vorangehenden Ansprüche, **dadurch gekennzeichnet, dass** die Trägerfolie einen spezifischen Durchgangswiderstand von mindestens $10^{13}$ Ω m aufweist.

**4.** Haftklebeband nach einem der vorangehenden Ansprüche, **dadurch gekennzeichnet, dass** die Trägerfolie einen Oberflächenwiderstand von mindestens $10^{15}$ Ω.

**5.** Haftklebeband nach einem der vorangehenden Ansprüche, **dadurch gekennzeichnet, dass** als Trägerfolie eine Folie auf Basis fluorierter polyolefinischer Kunststoffe eingesetzt wird, insbesondere eine Polyvinylfluoridfolie (PVF-Folie), eine Polyethylentetrafluorethylenfolie (PETFE-Folie), eine Tetrafluorethylen/Hexafluorethylen-Copolymer-Folie (FEP-Folie) oder eine Polyvinylidenfluoridfolie (PVDF-Folie).

**6.** Haftklebeband nach einem der vorangehenden Ansprüche, **dadurch gekennzeichnet, dass** der Fluorgehalt der Trägerfolie mindestens 15 Gew.-%, bevorzugt mindestens 20 Gew.-%, besonders bevorzugt mindestens 35 Gew.-% beträgt.

**7.** Haftklebeband nach einem der vorangehenden Ansprüche, **dadurch gekennzeichnet, dass** als Trägerfolie eine mehrschichtige, insbesondere coextrudierte, Folie eingesetzt wird.

**8.** Haftklebeband nach einem der vorangehenden Ansprüche, **dadurch gekennzeichnet, dass** die Trägerfolie mit einer reflektionsvermindernden und/oder einer oberflächenschützenden Beschichtung versehen ist.

**9.** Haftklebeband nach einem der vorangehenden Ansprüche, **dadurch gekennzeichnet, dass** als Haftklebemasse eine Masse auf (Meth-)Acrylatbasis eingesetzt wird, insbesondere eine solche Haftklebemasse, die zu zumindest 50 Gew.-% auf Monomeren basiert, gewählt aus der Gruppe der Acrylsäureester, Methacrylsäureester, Acrylsäure und Methacrylsäure.

**10.** Verwendung einer Haftklebefolie zur Verklebung von Bauteilen bei der Herstellung von Solarmodulen.

11. Verwendung nach Anspruch 10, **dadurch gekennzeichnet, dass** die Verwendung zur Solarzellenfixierung, als Oberflächenschutz und/oder zur Laminatfixierung erfolgt.

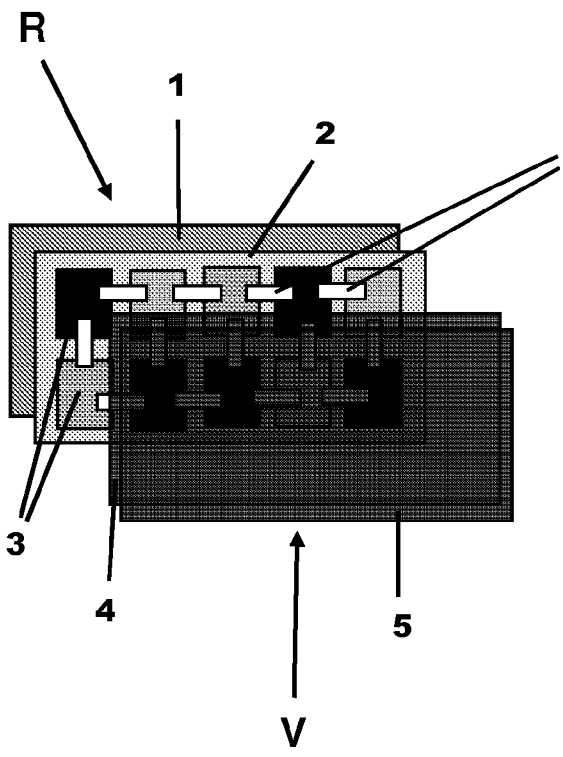


Fig. 1

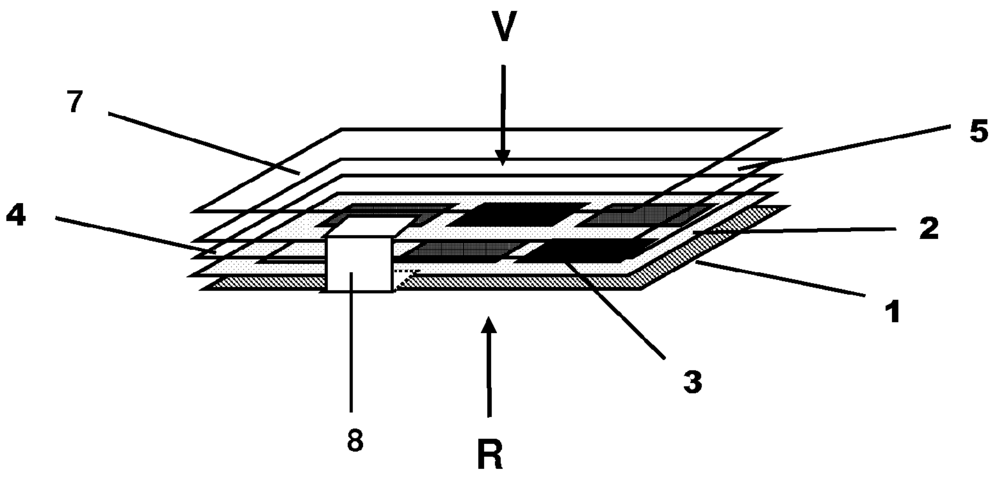


Fig. 2

Europäisches Patentamt
European Patent Office
Office européen des brevets

# EUROPÄISCHER RECHERCHENBERICHT

Nummer der Anmeldung
EP 09 16 8778

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,P | EP 2 042 579 A1 (TESA AG [DE]) 1. April 2009 (2009-04-01)<br>* Zusammenfassung *<br>* Ansprüche 1, 3, 10 *<br>* Absatz [0026] *<br>* Absatz [0036] *<br>* Absatz [0048] - Absatz [0051] *<br>* Absatz [0062] - Absatz [0065] *<br>* Absatz [0159] - Absatz [0163] *<br>* Absatz [0173] *<br>----- | 1-4,7-9 | INV.<br>C09J7/02<br>H01L31/048 |
| X<br><br>Y | US 2005/133085 A1 (SHIMADA KEIJI [JP]) 23. Juni 2005 (2005-06-23)<br>* Ansprüche 1, 13, 15 *<br>* Absatz [0020] - Absatz [0031] *<br>----- | 10-11<br><br>5-6 | |
| Y | WO 2008/012167 A2 (TESA AG [DE]; HUSEMANN MARC [DE]; STORBECK REINHARD [DE]) 31. Januar 2008 (2008-01-31)<br>* Ansprüche 1, 2, 5, 8 *<br>----- | 5-6 | |
| | | | RECHERCHIERTE SACHGEBIETE (IPC) |
| A | DE 10 2005 034745 A1 (TESA AG [DE]) 25. Januar 2007 (2007-01-25)<br>* Absatz [0047] - Absatz [0064] *<br>* Absatz [0070] - Absatz [0098] *<br>----- | 1-9 | C09J<br>H01L |

Der vorliegende Recherchenbericht wurde für alle Patentansprüche erstellt

| Recherchenort | Abschlußdatum der Recherche | Prüfer |
|---|---|---|
| München | 8. Januar 2010 | Siemsen, Beatrice |

2

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR.

EP 09 16 8778

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-01-2010

| Im Recherchenbericht angeführtes Patentdokument | Datum der Veröffentlichung | Mitglied(er) der Patentfamilie | Datum der Veröffentlichung |
|---|---|---|---|
| EP 2042579 A1 | 01-04-2009 | CN 101392158 A | 25-03-2009 |
| | | DE 102007045168 A1 | 02-04-2009 |
| | | JP 2009102619 A | 14-05-2009 |
| | | US 2009081430 A1 | 26-03-2009 |
| US 2005133085 A1 | 23-06-2005 | JP 4157459 B2 | 01-10-2008 |
| | | JP 2005136194 A | 26-05-2005 |
| WO 2008012167 A2 | 31-01-2008 | CN 101495583 A | 29-07-2009 |
| | | DE 102006035786 A1 | 13-03-2008 |
| | | EP 2049607 A2 | 22-04-2009 |
| | | KR 20090035632 A | 09-04-2009 |
| | | US 2009208739 A1 | 20-08-2009 |
| DE 102005034745 A1 | 25-01-2007 | AT 429476 T | 15-05-2009 |
| | | CN 101223255 A | 16-07-2008 |
| | | DE 112005003607 A5 | 10-07-2008 |
| | | EP 1910490 A1 | 16-04-2008 |
| | | WO 2007009501 A1 | 25-01-2007 |
| | | ES 2324826 T3 | 17-08-2009 |
| | | JP 2009501813 T | 22-01-2009 |
| | | KR 20080036100 A | 24-04-2008 |
| | | US 2008220252 A1 | 11-09-2008 |

EPO FORM P0461

Für nähere Einzelheiten zu diesem Anhang : siehe Amtsblatt des Europäischen Patentamts, Nr.12/82

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Nicht-Patentliteratur


- Handbook of Pressure Sensitive Adhesive Technology. 1989
- **T.G. Fox.** *Bull. Am. Phys. Soc.,* 1956, vol. 1, 123
- **Houben Weyl.** *Methoden der Organischen Chemie,* vol. E 19a, 60-147